(19) Europäisches Patentamt
European Patent Office
Office européen des brevets

(11) **EP 1 049 937 B1**

(12) **EUROPÄISCHE PATENTSCHRIFT**

(45) Veröffentlichungstag und Bekanntmachung des Hinweises auf die Patenterteilung:
**06.03.2002 Patentblatt 2002/10**

(21) Anmeldenummer: **99907253.1**

(22) Anmeldetag: **20.01.1999**

(51) Int Cl.⁷: $G01R\ 23/16$

(86) Internationale Anmeldenummer:
**PCT/DE99/00120**

(87) Internationale Veröffentlichungsnummer:
**WO 99/38018 (29.07.1999 Gazette 1999/30)**

(54) **VERFAHREN ZUR SCHÄTZUNG DER FREQUENZ EINES ZEITSIGNALS**

METHOD FOR ESTIMATING THE FREQUENCY OF A TIME SIGNAL

PROCEDE POUR ESTIMER LA FREQUENCE D'UN SIGNAL HORAIRE

(84) Benannte Vertragsstaaten:
**AT CH DE ES FR GB IT LI**

(30) Priorität: **22.01.1998 DE 19802193**

(43) Veröffentlichungstag der Anmeldung:
**08.11.2000 Patentblatt 2000/45**

(73) Patentinhaber: **EADS Deutschland GmbH 81663 München (DE)**

(72) Erfinder: **SCHEPPACH, Frank D-89231 Neu-Ulm (DE)**

(74) Vertreter: **Meel, Thomas Dornier GmbH L H G 88039 Friedrichshafen (DE)**

(56) Entgegenhaltungen:
EP-A- 0 803 733 US-A- 4 630 228
US-A- 5 291 081 US-A- 5 519 402

• GOTO Y: "HIGHLY ACCURATE FREQUENCY INTERPOLATION OF APODIZED FFT MAGNITUDE- MODE SPECTRA" APPLIED SPECTROSCOPY, Bd. 52, Nr. 1, 1. Januar 1998, Seiten 134-138, XP000774810

**Beschreibung**

Die Erfindung betrifft ein Verfahren zur Schätzung der Frequenz eines Zeitsignals mittels einer diskreten Fourier-Transformation und Interpolation zwischen Stützstellen des DFT-Spektrums.

Verfahren zur Frequenzschätzung unter Einsatz einer Fourier-Transformation kommen beispielsweise bei FMCW-Radarsystemen zur Anwendung. Von Dr. J. Otto ist in "Mikrowellensensor zur Füllstandsmessung", Sensoren-Technologie und Anwendungen, VDI-Berichte 939, 1992, Seiten 95-100 und in "Mikrowellen messen Füllstände" in Design & Elektronik-Sensortechnik, Mai 1997, Heft 10, Seite 40-44 die Anwendung des FMCW-Prinzips zur Füllstandsmessung beschrieben. Vom selben Autor sind im Tagungsband zu MessComp, 5.-7.9.1995, Seite 113-117 digitale Methoden zur Frequenzbestimmung bei mono- und multifrequenten Signalen unter Einsatz von verschiedenen Interpolationsverahren zu Fourier-Spektren beschrieben. Über die Interpolation kann die Entfernungsmessung durch Frequenzschätzung erheblich genauer erfolgen. Angegeben sind beispielsweise Interpolation durch Schwerpunktsetzung oder durch Parabelapproximation.

Ein Verfahren zur Schätzung der Frequenz eines Zeitsignals mittels einer Fourier-Transformation und der Interpolation zwischen Stützstellen der diskreten Fourier-Transformation unter Verwendung einer Hamming-Fensterung ist in "Highly Accurate Frequency Interpolation of Apodized FFT Magnitude-Mode Spectra", von Goto in Applied Spectroscopy, Vol. 52, Nr. 1, 1998, Seite 134 ff. beschrieben.

In tm-Technische Messen 62 (2/95), S. 66-73 sind von Stolle, Heuermann und Schiek Auswertemethoden zur Präzisionsentfernungsmessung mit FMCW-Systemen und deren Anwendung im Mikrowellenbereich beschrieben.

In "High-Accuracy Analog Measuerements via Interpolated FFT" von Jain, Collins und Davis in IEEE Vol. IM-28, No. 2, Juni 1979, Seiten 113-122 und "Interpolation Algorithms for Discrete Fourier Transforms of Weighted Signals", von Grandke in IEEE Vol. IM-32, No. 2, Juni 1983, Seiten 350-355 sind Verfahren zur genauen Frequenzschätzung eines fouriertransformierten Zeitsignals durch Interpolation beschrieben.

Weitere Verfahren zur Frequenzschätzung finden sich in "Calculation of Narrow-Band Spectra by Directed Decimation" von Liu und Mintzer in IEEE Transactions, Vol. ASSP-26, No. 6, Dezember 1978, Seite 529 bis 534 und in "Some Aspects of the Zoom Transform" von Yip in IEEE Transactions on Computers, Vol. c-25, No. 3, März 1976, Seite 287 bis 296.

Die Feinbestimmung der Frequenz wird bei den bekannten auf Fourier-Spektren aufbauenden Verfahren vorrangig mittels durch einfache Gleichungen beschreibbarer Interpolationsformeln für die Signalfilterung nach Rechteck- oder Hanning-Fensterfunktionen vorgenommen. Die Hanning-Interpolationsformel kann unter Annahme eines unendlich ausgedehnten komplexen Zeitsignals und unter Inkaufnahme des systematischen Fehlers dieser Formel auch auf ein Signal mit Hamming-Fensterung übertragen werden.

Der Erfindung liegt die Aufgabe zugrunde, ein hinsichtlich Genauigkeit und Verarbeitungsaufwand vorteilhaftes Verfahren zur Frequenzschätzung anzugeben.

Die Erfindung ist im Patentanspruch 1 beschrieben. Die Unteransprüche enthalten vorteilhafte Ausgestaltungen und Weiterbildungen der Erfindung.

Das erfindungsgemäße Verfahren macht sich die an sich bekannten vorteilhaften spektralen Eigenschaften der Hamming-Fensterfunktion zunutze und erlaubt insbesondere eine Erhöhung der Genauigkeit der Frequenzschätzung bei Einziel-Detektion mit geringer Komplexität durch den nicht erforderlichen Einsatz numerischer Verfahren zur Bestimmung der Interpolationsgröße. Die Erfindung ist insbesondere darstellbar als geschlossene Lösung einer systematisch korrekten . Gleichung für unendlich lange reelle Einton-Signale als Näherung für reelle Signale endlicher Länge.

Bei dem erfindungsgemäßen Verfahren sind keine weiteren Näherungen zur Bestimmung der Interpolationsgröße, etwa durch numerische iterative Auswertung einer Interpolationsvorschrift erforderlich. Die Offline-Erstellung von Interpolationswerten und deren tabellarische Ablage ist zwar möglich und vorteilhaft, vorzugsweise wird aber eine Online-Berechnung anhand einer vorgegebenen, die geschlossene Lösung bildenden Rechenvorschrift durchgeführt. Bei Vorgabe einer tabellarischen Auswertung ist die maximale Abweichung der gespeicherten Werte vorteilhafterweise von der Auflösung bei der Bestimmung des Betragsverhältnisses $\alpha$ von Nebenmaximum zu Hauptmaximum abhängig und vorzugsweise kleiner als der m-te Teil des Maximalwertes der Interpolationsgröße mit m als Anzahl der Auflö-sungsinkremente des Definitionsbereichs von $\alpha$.

Die Erfindung ist nachfolgend unter Herleitung und Darstellung einer bevorzugten Berechnungsvorschrift wei-ter veranschaulicht.

Der Einfachheit halber wird ein monofrequentes Zeitsignal der Frequenz $f_0$ betrachtet, welches innerhalb eines begrenzten Zeitfensters der Länge N · $T_A$ in Form von N diskreten Abtastwerten s(k) im Abstand der Abtastfolgezeit $T_A$ als diskretes Zeitsignal

$$s(k) = V \cdot \sin(2\pi f_0 \cdot k \cdot T_A + \varphi) \qquad 0 \leq k \leq N-1$$

mit V als Amplitude und $\varphi$ als Anfangsphase (k=0) vorliegt.

Das verallgemeinerte Cosinus-Fenster

$$w(i) \; = \; a-(1-a)\cdot\cos\left(2\pi\cdot\frac{i}{N}\right)$$

der Hamming-Fenster-Funktion mit a=0,54 besitzt die Fourier-Transformierte

$$W(k) \; = \; N\cdot\left(-\frac{1-a}{2}\cdot\delta(k+1)+a\cdot\delta(k)-\frac{1-a}{2}\cdot\delta(k-1)\right)$$

mit k als diskreter Stützstelle des Spektrums und $\delta$ als Dirac'scher Deltafunktion.

Durch Faltung der Fourier-Transformierten W(k) der Hamming-Fenster-Funktion mit dem Zeitsignal s(k) und Anwendung der diskreten Fourier-Transformation DFT erhält man das DFT-Spektrum $S_W(i)$ des mit dem Hamming-Fenster gewichteten Zeitsignal mit i als Nummer der diskreten Stützstellen (Bin) des Spektrums.

Die Frequenz $f_0$ des Zeitsignals fällt im Regelfall nicht genau mit einer der diskreten Frequenzstützstellen $f_i = i/(N\cdot T_A)$ des DFT-Spektrums zusammen. Für die a priori unbekannte Frequenz $f_0$ ergeben sich dann im DFT-Sepktrum mehrere Linien, die ein Hauptmaximum bei i=l als betragsstärkste Linie und ein dieser benachbartes (größtes) Nebenmaximum bei i=l+1 oder i=l-1 zeigen. Die gesuchte Frequenz $f_0$ liegt im Frequenzintervall zwischen Bin i=l-1 und Bin i=l+1 im Korrekturabstand d von der Hauptlinie i=l bei $f_0 = \lambda/(N\cdot T_A)$ mit $\lambda = l+d$ und -1<d<+1, wobei d auch als Sub-Bin bezeichnet wird.

Bevorzugterweise werden der genaueren Frequenzschätzung über die Berechnung des Korrekturabstands die Größe des Hauptmaximums $S_W(l)$ und die Größe des Nebenmaximums $S_W(l\pm1)$ als Meßgrößen aus dem DFT-Spektrum zugrundegelegt. Vorzugsweise wird aus den beiden Größen das Verhältnis

$$\alpha = \frac{|S_W(\ell\pm1)|}{|S_W(\ell)|}$$

gebildet, welches einen Definitionsbereich $0\leq\alpha\leq1$ besitzt. Unter Verwendung dieses Verhältnisses als Hilfsgröße läßt sich für die Bestimmung des Korrekturabstandes d vorteilhafterweise die Beziehung

$$\alpha = \frac{|(-2 + 4d - 2d^2 + a\cdot(-2 - 8d + 4d^2))\cdot(d + 1)|}{|-2d + a\cdot(4d^2 - 2)\cdot(d - 2)|}$$

ableiten, wobei als Vereinfachung lediglich einige Kleinwinkelnäherungen gemacht sind. Gemäß der Definition des Hamming-Fensters ist a=0,54 und die vorstehende Beziehung für $\alpha$ läßt sich in die Gleichung dritten Grades

$$d^3(0,16\alpha+0,16)+d^2(-0,32\alpha-0,16)+d(-1,08\alpha-1,24)+2,16\alpha-0,92=0$$

umformen. Diese Gleichung zeigt vorteilhafterweise für den Definitionsbereich von $\alpha$ ($0\leq\alpha\leq1$) eine geschlossene Lösung, nach welcher vorzugsweise die Berechnung des Korrekturabstandes durchgeführt wird. Unter Einführung einiger Hilfsgrößen für die vereinfachte Notation ergibt sich die geschlossene Lösung für

$$d = \frac{x}{3} - \frac{a_2}{2}$$

wobei

$$x = -2 \cdot \sqrt{\left|\frac{p}{3}\right|} \cdot \cos\left(\frac{\varphi}{3} + \frac{\pi}{3}\right)$$

$$\varphi = \arccos\left(-\frac{q}{2} \cdot \sqrt{\left(\frac{|p|^3}{3}\right)}\right)$$

$$p = a_1 - \frac{1}{3}a_2{}^2$$

$$q = \frac{2}{27}a_2{}^3 - \frac{1}{3}a_1 a_2 + a_0$$

$$a_0 = (2,16\alpha - 0,92)/c$$

$$a_1 = (-1,08\alpha - 1,24)/c$$

$$a_2 = (-0,32\alpha - 0,16)/c$$

$$c = 0,16\alpha + 0,16.$$

Die vorstehende Gleichung für d bildet eine analytische und eindeutige Lösung für das Problem der Interpolation zwischen Stützstellen des DFT-Spektrums eines mit einer Hamming-Fenster-Funktion gefilterten Zeitsignals auf der Basis des Verhältnisses des Hauptmaximums und dessen Nebenmaximum.

Bei der Ableitung der Lösung für d ist die Reihenfolge von $S_W(l)$ für das Hauptmaximum und $S_W(l+1)$ für das Nebenmaximum zugrunde gelegt. Für die Lage des Nebenmaximums bei i=l-1 ist zur genauen Schätzung der Frequenz nach $\lambda=l+d$ lediglich das Vorzeichen des ermittelten Werts für den Korrekturabstand d umzukehren.

**Patentansprüche**

**1.** Verfahren zur Schätzung der Frequenz eines Zeitsignals mittels einer diskreten Fourier-Transformation des Zeitsignals und Interpolation zwischen Stützstellen des DFT-Spektrums, wobei das Zeitsignal mit einer Hamming-Fenster-Funktion gefiltert wird, **dadurch gekennzeichnet, daß** die Interpolation nach einer mathematisch geschlossenen Lösung vorgenommen wird,
daß die Interpolation auf der Basis des Betragsverhältnisses $\alpha$ des Hauptmaximums $S_w(l)$ und des Nebenmaximums $S_w(l+1)$ im DFT-Spektrum,

$$\alpha = |S_W(l\pm1)| \,/\, |S_W(l)|$$

vorgenommen wird.,
wobei ein
Korrekturabstand d (-1<d<+1) gegen die Spektrallinie des Hauptmaximums aus der Beziehung

$$\alpha = \frac{|(-2 + 4d - 2d^2 + a \cdot (-2 - 8d + 4d^2)) \cdot (d + 1)|}{|-2d + a \cdot (4d^2 - 2) \cdot (d - 2)|}$$

mit a = 0,54 bestimmt wird, und
wobei
der Korrekturabstand d nach der für den Bereich $0 \leq \alpha \leq 1$ eindeutigen Lösung für d mittels der Beziehung zwischen $\alpha$ und d errechnet wird.

2. Verfahren nach Anspruch 1, **dadurch gekennzeichnet, daß** der Korrekturabstand nach

$$d = x/3 - a_2/2$$

mit

$$x = -2 \cdot \sqrt{\left|\frac{p}{3}\right|} \cdot \cos\left(\frac{\varphi}{3} + \frac{\pi}{3}\right) \qquad \left[\varphi = arc\,cos\left[-\frac{q}{2} \cdot \sqrt{\left(\frac{|p|}{3}\right)^3}\right]\right]$$

$$p = a'_1 - \frac{1}{3}a_2{}^2,$$

$$q = \frac{2}{27}a_2{}^3 - \frac{1}{3}a_1a_2 + a_0,$$

$$a_0 = (2{,}16\alpha - 0{,}92)/c$$

$$a_1 = (-1{,}08\alpha - 1{,}24)/c$$

$$a_2 = (-0{,}32\alpha - 0{,}16)/c$$

und

$$c = 0{,}16\alpha + 0{,}16$$

berechnet wird.

3. Verfahren nach Anspruch 1, **dadurch gekennzeichnet, daß** der Korrekturabstand d aus einer Zuordnungtabelle entnommen wird.

4. Verfahren nach Anspruch 3, **dadurch gekennzeichnet, daß** die Tabelle durch den Wert des Betragsverhältnisses $\alpha$ oder einen daraus abgeleiteten Wert adressiert ist.


**Claims**

1. Method for estimating the frequency of a time signal by means of a discrete Fourier transformation of the time signal and interpolation between support points in the DFT spectrum, with the time signal being filtered using a Hamming window function, <u>**characterized** in that</u> the interpolation is carried out using a mathematically closed solution,
**in that** the interpolation is carried out on the basis of the magnitude ratio $\alpha$ of the main maximum $S_w(e)$ and of the secondary maximum $S_w(e+1)$ in the DFT spectrum

$$\alpha = |S_w(e\pm1)| \, / \, |S_w(e)|$$

in which case
correction margin d (-1<d<+1) is defined with respect to the spectral line of the main maximum from the relationship

$$\alpha = \frac{|(-2 + 4d - 2d^2 + a \cdot (-2 - 8d + 4d^2)) \cdot (d + 1)|}{|-2d + a \cdot (4d^2 - 2) \cdot (d - 2)|}$$

where a=0.54, and
in which **case**
the correction margin d is calculated using the unique solution for the range 0<$\alpha$<1 for d, by means of the relationship between $\alpha$ and d.

2. Method according to Claim 1, **characterized in that** the correction margin is calculated using

$$d = x/3 - a_2/2$$

where

$$x = -2 \cdot \sqrt{\left|\frac{p}{3}\right|} \cdot \cos\left(\frac{\varphi}{3} + \frac{\pi}{3}\right) \qquad \left[\varphi = arccos\left(-\frac{q}{2} \cdot \sqrt{\left(\frac{|p|^3}{3}\right)}\right)\right]$$

$$p = a'_1 - \frac{1}{3}a_2^{\,2},$$

$$q = \frac{2}{27}a_2^{\,3} - \frac{1}{3}a_1 a_2 + a_0,$$

$$a_0 = (2.16\alpha - 0.92)/c$$

$$a_1 = (-1.08\alpha - 1.24)/c$$

$$a_2 = (-0.32\alpha - 0.16)/c$$

and

$$c = 0.16\alpha + 0.16$$

3. Method according to Claim 1, **characterized in that** the correction margin d is taken from an association table.

4. Method according to Claim 3, **characterized in that** the table is addressed by the value of the magnitude ratio $\alpha$ or by a value derived from this.

**Revendications**

1. Procédé pour estimer la fréquence d'un signal horaire au moyen d'une transformation de Fourier discrète du signal horaire et de l'interpolation entre les points d'appui du spectre de la DFT, le signal horaire étant ici filtré avec une fonction fenêtre de Hamming, **caractérisé en ce que** l'interpolation est réalisée selon une résolution mathématique fermée, **en ce que** l'interpolation est réalisée sur la base du rapport absolu $\alpha$ du maximum principal $S_w$ (l) et du maximum secondaire $S_w$ (l+1) dans le spectre de la DFT

$$\alpha = |S_w(l\pm 1)|/|S_w(l)|,$$

dans quel cas un
écart de bande de correction d (-1 < d < +1) par rapport à la ligne spectrale du maximum principal est déterminé à partir de l'équation

$$\alpha = \frac{|(-2 + 4d - 2d^2 + a.(-2 - 8d + 4d^2))\cdot(d + 1)|}{|-2d + a.(4d^2 - 2)\cdot(d - 2)|}$$

avec a = 0,54, et
dans quel cas
l'écart de correction d est calculé d'après la résolution explicite pour la plage $0 \leq \alpha \leq 1$ pour d au moyen de la relation entre $\alpha$ et d.

2. Procédé selon la revendication 1, **caractérisé en ce que** l'écart de correction est calculé selon

$$d = x/3 - a_2/2$$

avec

$$x = -2\cdot\sqrt{\left|\frac{p}{3}\right|}\cdot cos\left(\frac{\varphi}{3} + \frac{\pi}{3}\right)$$

$$\varphi = arccos\left(-\frac{q}{2}\sqrt{\frac{|p|^3}{3}}\right)$$

$$p = a'_1 - \frac{1}{3}a_2^2,$$

$$q = \frac{2}{27}a_2^3 - \frac{1}{3}a_1a_2 + a_0,$$

$$a_0 = (2,16\alpha - 0,92)/c,$$

$$a_1 = (-1,08\alpha - 1,24)/c,$$

$$a_2 = (-0,32\alpha - 0,16)/c$$

et

$$c = 0,16\alpha + 0,16.$$

3. Procédé selon la revendication 1, **caractérisé en ce que** l'écart de correction d est prélevé dans un tableau de référence.

**4.** Procédé selon la revendication 3, **caractérisé en ce que** le tableau est adressé par la valeur du rapport absolu α ou par une valeur qui découle.